# EUROPEAN PATENT APPLICATION

(11) **EP 1 814 373 A1**
(43) Date of publication of application: **01.08.2007**
(21) Application number: 06812008.8
(22) Date of filing: 19.10.2006
(51) Int. Cl.: H05K 3/46, H05K 1/11, H05K 3/40

(54) **MULTILAYER PRINTED WIRING BOARD AND ITS MANUFACTURING METHOD**

(30) Priority: 20.10.2005 JP 2005305489
(71) Applicant: MATSUSHITA ELECTRIC INDUSTRIAL CO., LTD., Osaka 571-8501 (JP)
(72) Inventor: HIRAI, Shogo c/o Matsushita Electric Ind., Co., Ltd., IPROC, Osaka-shi, Osaka 540-6319 (JP); ECHIGO, Fumio c/o Matsushita Electric Ind., Co., Ltd., IPROC, Osaka-shi, Osaka 540-6319 (JP); NAKAMURA, Tadashi c/o Matsushita Electric Ind., Co., Ltd., IPROC, Osaka-shi, Osaka 540-6319 (JP); SUGAWA, Toshio c/o Matsushita Electric Ind., Co., Ltd., IPROC, Osaka-shi, Osaka 540-6319 (JP)
(74) Representative: Pautex Schneider, Nicole Véronique
(86) International application number: PCT/JP2006/320820
(87) International publication number: WO 2007/046459

(57) **Abstract**

In a case of multilayer circuit boards where a plurality of conventional films are used as insulating layers, the films are connected with each other using an adhesive, and therefore, the adhesive sometimes negatively affects reduction in thickness. Therefore, a plurality of two-sided boards with films used therein are pasted together with a paste connection layer interposed therebetween, the paste connection layer being configured such that through holes formed in a prepreg are filled in with a conductive paste which is then cured, and second wires are electrically connected with each other through the conductive paste with which the through holes formed in the paste connection layer in advance are filled in, and thus, a multilayer board can be provided without using an adhesive, and the entirety of the multilayer circuit board can be reduced in thickness.

## Description

### TECHNICAL FIELD

The present invention relates to a multilayer printed wiring board which is used for a cellular phone and an ultra-compact portable terminal, a multilayer printed wiring board which is used for an interposer used when a semiconductor chip is mounted as a bare chip, and a manufacturing method for the same.

### BACKGROUND ART

Conventional multilayer printed wiring boards (hereinafter simply referred to as multilayer boards) of this type are known to be multilayer boards where IVH's (inner via holes) are formed at arbitrary positions. An example of such conventional multilayer boards is disclosed in, for example, Unexamined Japanese Patent Publication No. 2002-353619.

However, further reduction in thickness of the layers of multilayer boards has been desired in the market. In the following, a multilayer board where films are used as a means for reducing the thickness of the layers of the multilayer board is described.

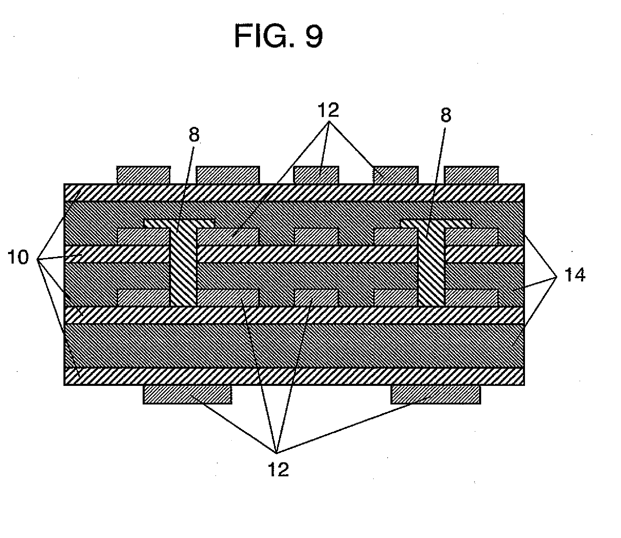

FIG. 9 is a cross sectional diagram showing an example of a conventional multilayer board, which is an example of a multilayer wiring board where films are layered using an adhesive. In FIG. 9, predetermined patterns are formed of wires 12 on films 10. In addition, a plurality of films 10 having wires 12 are pasted together using adhesive 14. In addition, IVH's 8 are formed in necessary portions, and thus, wires 12 formed in different layers are connected with each other.

In the above described conventional configuration, however, adhesive 14 is used for connection between films 10, and thus, there is a limit to reduction in thickness of the layers.

In a case of the configuration shown in FIG. 9, for example, films 10 where wires 12 are formed on one surface are layered, and therefore, when a multilayer board having four layers is fabricated, the total thickness of the required seven layers; three layers of adhesive 14 and four layers of films 10, is great, making reduction in thickness of the layers difficult.

Meanwhile, as a modification of the configuration shown in FIG. 9, it is possible to prepare two films 10 where wires 12 are formed on both sides and then paste these together with adhesive 14, so that a multilayer board having four wiring pattern layers is provided. In this case, films 10 where wires 12 are formed on both sides are pasted together with adhesive 14. At the time of this pasting, however, adhesive 14 is softened and becomes fluid, and therefore, there is a possibility that facing wires 12 may short circuit.

The present invention is to solve the above described problem with the prior art, and provides a multilayer board using a prepreg (sheet material) instead of the adhesive for layering films.

### DISCLOSURE OF THE INVENTION

In order to solve the above described problem with the prior art, two-sided printed wiring boards which use a resin film having wire patterns formed on the front and rear surface are pressed together with a prepreg in between so as to be integrated according to the present invention.

In the present invention, films having wires formed on both surfaces are pasted together using, for example, a woven cloth impregnated with a resin, as a prepreg, and therefore, wires can be prevented from short circuiting by the woven cloth included in the prepreg, even in a case where the films are pressed under high pressure. In addition, through holes are formed in the prepreg in advance and filled in with a conductive paste, and thus, it becomes possible to form IVH's at the same time as the pasting of the two-sided printed wiring boards.

As described above, in a multilayer printed wiring board and a manufacturing method for the same according to the present invention, films are layered using a prepreg instead of an adhesive, and thus, an extremely thin multilayer printed wiring board having IVH's can be manufactured.

### BRIEF DESCRIPTION OF THE DRAWINGS

FIG. 1 is a cross sectional diagram showing a multilayer board according to the first embodiment.
FIG. 2A is a first cross sectional diagram for illustrating a manufacturing method for a four layer board according to the second embodiment.
FIG. 2B is a second cross sectional diagram for illustrating a manufacturing method for a four layer board according to the second embodiment.
FIG. 2C is a third cross sectional diagram for illustrating a manufacturing method for a four layer board according to the second embodiment.
FIG. 2D is a fourth cross sectional diagram for illustrating a manufacturing method for a four layer board according to the second embodiment.
FIG. 2E is a fifth cross sectional diagram for illustrating a manufacturing method for a four layer board according to the second embodiment.
FIG. 3 is a cross sectional diagram showing a multilayer board according to the third embodiment.
FIG. 4A is a first cross sectional diagram for illustrating a manufacturing method for a multilayer board according to the fourth embodiment.
FIG. 4B is a second cross sectional diagram for illustrating a manufacturing method for a multilayer board according to the fourth embodiment.
FIG. 4C is a third cross sectional diagram for illustrating a manufacturing method for a multilayer board according to the fourth embodiment.
FIG. 4D is a fourth cross sectional diagram for illustrating a manufacturing method for a multilayer board according to the fourth embodiment.
FIG. 4E is a fifth cross sectional diagram for illustrating a manufacturing method for a multilayer board according to the fourth embodiment.
FIG. 5 is a cross sectional diagram showing a multilayer board according to the fifth embodiment.
FIG. 6A is a first cross sectional diagram for illustrating a manufacturing method for a multilayer board according to the sixth embodiment.
FIG. 6B is a second cross sectional diagram for illustrating a manufacturing method for a multilayer board according to the sixth embodiment.
FIG. 6C is a third cross sectional diagram for illustrating a manufacturing method for a multilayer board according to the sixth embodiment.
FIG. 6D is a fourth cross sectional diagram for illustrating a manufacturing method for a multilayer board according to the sixth embodiment.
FIG. 6E is a fifth cross sectional diagram for illustrating a manufacturing method for a multilayer board according to the sixth embodiment.
FIG. 6F is a sixth cross sectional diagram for illustrating a manufacturing method for a multilayer board according to the sixth embodiment.
FIG. 7A is a first cross sectional diagram for illustrating a manufacturing method for a multilayer board according to the seventh embodiment.
FIG. 7B is a second cross sectional diagram for illustrating a manufacturing method for a multilayer board according to the seventh embodiment.
FIG. 7C is a third cross sectional diagram for illustrating a manufacturing method for a multilayer board according to the seventh embodiment.
FIG. 7D is a fourth cross sectional diagram for illustrating a manufacturing method for a multilayer board according to the seventh embodiment.
FIG. 8A is a first cross sectional diagram for illustrating a manufacturing method for a multilayer board according to the ninth embodiment.
FIG. 8B is a second cross sectional diagram for illustrating a manufacturing method for a multilayer board according to the ninth embodiment.
FIG. 8C is a third cross sectional diagram for illustrating a manufacturing method for a multilayer board according to the ninth embodiment.
FIG. 8D is a fourth cross sectional diagram for illustrating a manufacturing method for a multilayer board according to the ninth embodiment.
FIG. 9 is a cross sectional diagram showing an example of a conventional multilayer board.

### DESCRIPTION OF THE REFERENCE MARKS

- 102a, 102b: film
- 104a, 104b: first wire
- 106a, 106b, 106c, 106d: second wire
- 108: insulating layer
- 110: IVH
- 112: interlayer connection portion
- 114a, 114b: two-sided board
- 116a, 116b: paste connection layer
- 118: multilayer board
- 120: interlayer insulating layer
- 122: prepreg
- 124: through hole
- 126: conductive paste
- 128: blind via
- 130: metal film

### PREFERRED EMBODIMENTS FOR CARRYING OUT OF THE INVENTION

### (First Embodiment)

In the following, a multilayer board according to the first embodiment of the present invention is described in reference to the drawings.

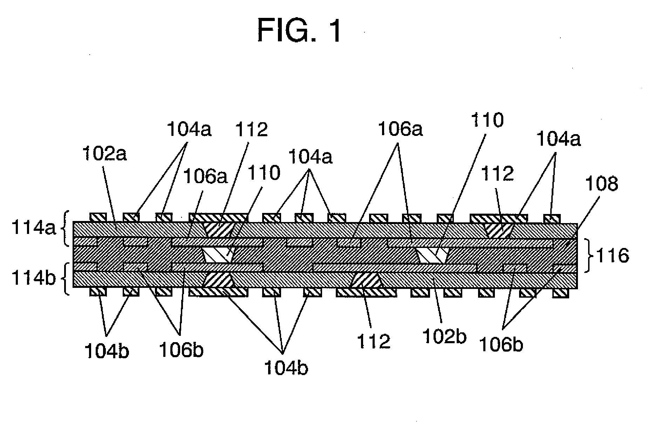

FIG. 1 is a cross sectional diagram showing a multilayer board according to the first embodiment of the present invention.

As shown in FIG. 1, the multilayer board has films 102a and 102b, first wires 104a and 104b, second wires 106a and 106b, insulating layer 108, IVH's 110, interlayer connection portions 112, two-sided boards 114a and 114b, and paste connection layer 116 as main components.

Here, first wires 104a are formed on one side of film 102a and second wires 106a are formed on the other side, and thus, two-sided board 114a is formed. Likewise, two-sided board 114b has first wires 104b and second wires 106b on the respective sides of film 102b, and the wires are connected to each other through interlayer connection portions 112. In addition, paste connection layer 116 is formed of insulating layer 108 and IVH's 110. In addition, two-sided board 114a and two-sided board 114b are integrated through paste connection layer 116. At the same time, second wires 106a on two-sided board 114a and second wires 106b on two-sided board 114b are electrically connected through IVH's 110. In terms of the thickness of these wire portions, second wires 106a formed on two-sided board 114a and second wires 106b formed on two-sided board 114b are buried in paste connection layer 116, and thus, the wires do not affect the thickness of paste connection layer 116.

Here, how to count wires and insulating layers is described in reference to FIG. 1. If the top in FIG. 1 is the front and the layers are counted from the top to the bottom, the first insulating layer, which is in the first layer counting from the front layer (corresponding to the front layer), corresponds to film 102a, the second insulating layer, which is in the second layer counting from the front layer, corresponds to insulating layer 108, and the third insulating layer, which is in the third layer counting from the front layer, corresponds to film 102b. Likewise, the first wires in the first layer counting from the front layer (or wires the first layer) correspond to first wires 104a, the second wires in the second layer counting from the front layer correspond to second wires 106a, the third wires in the third layer counting from the front layer correspond to second wires 106b, and the fourth wires in the fourth layers counting from the front layer correspond to first wires 104b. Here, though FIG. 1 shows a four layer structure (meaning there are wires in four layers) which is top-down symmetrical, and there is essentially no difference between counting from the top to the bottom and counting from the bottom to the top, assuming that the bottom as the front, as a principle, layers are counted from the top to the bottom, assuming that the top is the front, in the embodiments of the present invention.

In FIG. 1, electrical connections penetrating through insulating layer 108, which is the second insulating layer formed in the second layer counting from the front layer, correspond to IVH's 110. In addition, second wires 106a, which are wires in the second layer formed as the second layer counting from the front layer, and second wires 106b, which are wires in the third layer formed as the third layer counting from the front layer, are buried in the above described insulating layer 108.

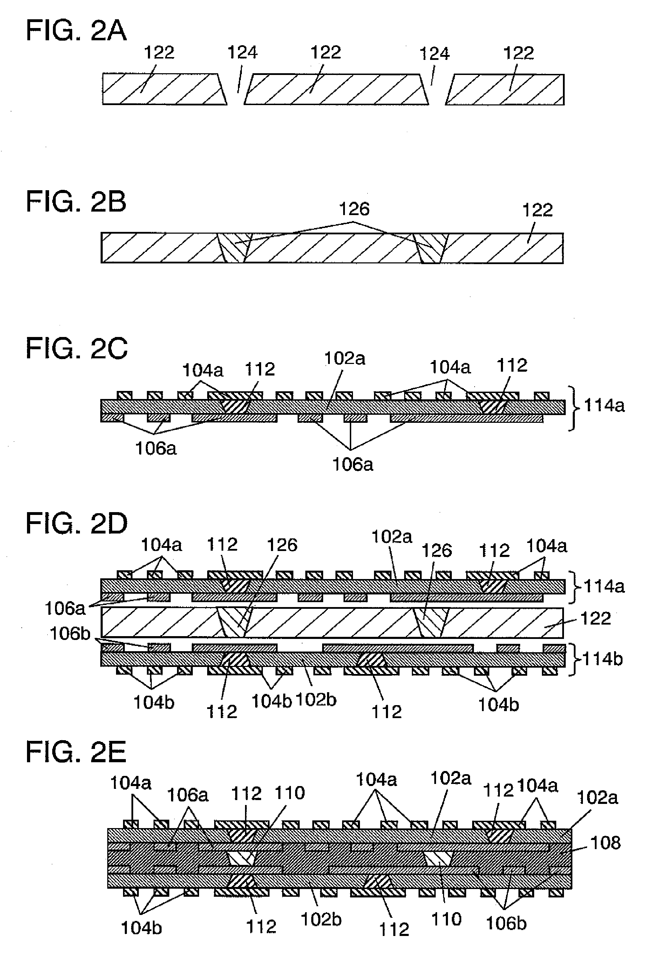

Here, IVH's 110 in the first embodiment are provided by filling through holes formed in insulating layer 108 (through holes 124 are described in reference to FIG. 2A below) with a conductive paste (conductive paste 126 is described in reference to FIG. 2B below). Thus, these IVH's 110 are formed between two-sided boards 114a and 114b so as to connect second wires 106a and 106b. In the first embodiment, IVH's 110 can be formed at arbitrary positions in paste connection layer 116. As described above, in FIG. 1, the thickness of the plurality of two-sided boards 114a and 114b using films 102 is not affected, and in addition, the layers are connected through IVH's 110.

Here, in the first embodiment, a prepreg can be selected as an example of the member which forms paste connection layer 116. This prepreg is made of a semi-cured resin. In addition, a curing conductive paste can be used as the member which forms IVH's 110. As described above, a prepreg and a curing conductive paste are used according to the present invention, and thus, a multilayer board can be formed without using an adhesive, so that the total thickness of the multilayer board can be greatly reduced. In addition, in a case where facing wires are connected to each other, the woven cloth included in the prepreg can prevent the wires from short circuiting through contact between the wires.

Here, it is desirable for the dimensions of the multilayer board to be approximately 300 mm × 500 mm +/- 200 mm. In a case where the dimensions are smaller than 100 mm × 300 mm, there is a possibility that the cost may increase, due to decrease in the number of products gained from the multilayer board. In addition, in a case where the dimensions of the board are greater than 500 mm × 700 mm, there may sometimes be negative effects, such that handling during the process sometimes become difficult or the dimensions change.

As described above, electrical connection through the second insulating layer (corresponding to insulating layer 108 in FIG. 1) which is formed in the second layer counting from the front layer is achieved through a conductive paste (corresponding to IVH's 110 in FIG. 1).

Thus, the second wires (corresponding to second wires 106a in FIG. 1), which are formed in the second layer counting from the front layer, and the third wires (corresponding to second wires 106b in FIG. 1), which are formed in the third layer counting from the front layer, are buried in the above described paste connection layer 116, and in addition, electrically connected.

As described above, in the first embodiment, a four layer board (meaning there are wires in four layers) can be formed without using an adhesive, and thus, it becomes possible to reduce the thickness of the four layer board.

### (Second Embodiment)

In the following, a manufacturing method for a multilayer board according to the second embodiment of the present invention is described. The second embodiment is an example of a manufacturing method for a four layer board, and corresponds to an example of a manufacturing method for the four layer board described in the first embodiment. FIGS. 2A to 2E are cross sectional diagrams showing a manufacturing method for a four layer board according to the second embodiment.

First, as shown in FIG. 2A, through holes 124 are formed in prepreg 122. At this time, it is desirable for through holes 124 to be formed in a state where the protective film is pasted on the surface of prepreg 122 in advance. A die, a drill, a laser or the like can be used to form through holes 124. Commercially available material, such as glass epoxy to be described below, an aramid epoxy or the like can be used as the material for the prepreg.

Next, as shown in FIG. 2B, through holes 124 are filled in with conductive paste 126. Prepreg 122 and a protective film (not shown) which is formed on the prepreg, for example, are used as a mask, and conductive paste 126 is rubbed against the mask using a squeegee, or voids in the mask are filled in with the conductive paste, and thus, it is possible to fill in only through holes 124 formed in prepreg 122 with conductive paste 126 in a self alignment manner. Then, the above described protective film is peeled off after the through holes are filled in with conductive paste 126, and thus, a state as that in FIG. 2B is gained.

FIG. 2C is a cross sectional diagram showing two-sided board 114a. In FIG. 2C, two-sided board 114a has first wires 104a formed on one side of film 102a and second wires 106a on the other side. In addition, interlayer connection portions 112 which are formed so as to penetrate through the above described film 102a make interlayer connection between first wires 104a and second wires 106a.

Here, it is desirable to use a resin film having high resistance to heat, such as a polyimide film or a polyamide film, as the material for film 102a, and an aramid film is particularly preferable. When a resin film having high resistance to heat is used, the system can be prevented from being thermally affected during the soldering process or the like. In addition, it is desirable to select film 102a of which the thickness is no greater than 100 µm, specifically, no less than 3 µm and no greater than 50 µm (it is desirable for it to be no greater than 30 µm, and further desirable for it to be no greater than 25 µm, if possible). Such an extremely thin film having resistance to heat is used so that the total thickness of the completed multilayer board can be reduced. Here, a board material where conductive layers are formed on both sides of such a film having resistance to heat without using an adhesive can be selected. When a copper covered film where a film having resistance to heat and a conductive layer are formed without using an adhesive as described above is used, the resistance to heat and reliability of the multilayer board can be increased.

FIG. 2D shows a state where the position of prepreg 122 of which the voids are filled in with conductive paste 126 in FIG. 2B and two-sided board 114a in FIG. 2C relative to each other is adjusted. As shown in FIG. 2D, two-sided boards 114a and 114b are set on both sides of prepreg 122 of which predetermined portions are filled in with conductive paste 126. Then, the position of second wires 106a and 106b on the prepreg 122 side and conductive paste 126 is adjusted. Then, heat and pressure are applied in the in a state where the wires and the conductive paste are positioned using a vacuum press (vacuum press not shown). Then, the pressed sample is taken out after the completion of vacuum pressing. FIG. 2E is a corresponding cross sectional diagram showing the sample after the completion of vacuum pressing.

Here, at the same time as pasting through application of pressure using a vacuum press, the sample is cured through application of heat at a predetermined profile of temperature. As a result, prepreg 122 is once softened and after that cured, so as to be converted to insulating layer 108. When prepreg 122 is softened, second wires 106a and 106b formed on two-sided boards 114a and 114b are buried in such a manner that the thickness of the wires does not affect the total thickness. Then, prepreg 122 is cured in such a state that the thickness of the wires does not affect the total thickness so as to be converted to insulating layer 108, and thus, two-sided boards 114a and 114b are firmly secured. In addition, conductive paste 126 which is buried in prepreg 122 is cured at the same time so as to be converted to IVH's 110. In this manner, a four layer board having IVH's 110 is formed. Thus, the effect of the thickness of second wires 106a and 106b is reduced, and the unevenness resulting from the wires is reduced.

Next, the prepreg is described. Here, prepreg (sheet material on which an impregnating process is carried out in advance) is a fiber material or a woven cloth impregnated with an active resin. The prepreg is such in a state as to not yet be completely cured, and therefore, the entirety can be formed at once through application of energy. When a prepreg is used in this manner, wires can be prevented from short circuiting through contact at the time of formation, and furthermore, deformation and inconsistency in the dimensions can be prevented at the time of molding through pressure, and in addition, it becomes possible to increase the strength of the completed multilayer board. Here, it is desirable to use a thermosetting resin as the resin for impregnation. As the thermosetting resin, an epoxy resin or an imide resin can be used. In addition, as the fiber material or woven cloth, polyamide or aramid members which include an aromatic can be used, in addition to glass fibers.

Here, it is desirable for the temperature at which the prepreg is cured to be in a range from 85 °C to 220 °C. In a case where the temperature is 230 °C or higher, there is inconsistency in the curing of the resin, and sometimes the precision in terms of the dimensions is affected. In addition, in a case where, the temperature is lower than 85 °C, the time for curing the resin increases, and sometimes a state after curing is affected. In addition, in a case where the thickness of film 102 is as small as 50 µm or lower, it is desirable to cure prepreg 122 at a temperature ranging from 180 °C to 220 °C. By doing so, second wires 106a and 106d formed on the prepreg 122 side from among the wires formed on the surface of two-sided boards 114a and 114b can be buried in prepreg 122.

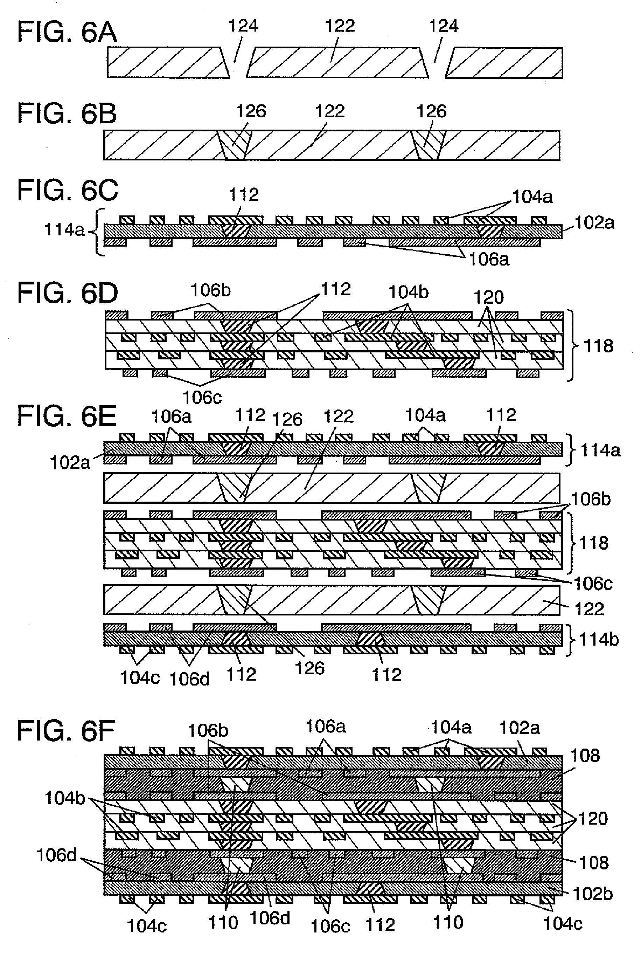

In addition, it is desirable for the pressure to be in a range from 2 MPa (megapascals; unit for pressure) to 6 MPa. In a case of less than 2 MPa, there is a possibility of there being inconsistency in the adhesiveness of the multilayer board shown in FIG. 6F. In addition, it is desirable for the time for applying pressure to be 1 minute or longer and less than 3 hours. In a case where the time for applying pressure is less than 1 minute, there is sometimes inconsistency due to the pressure. In addition, in a case where the time for applying pressure exceeds 3 hours, the productivity is affected. Therefore, it is desirable for the pressure to be no less than 2 MPa and no higher than 6MPa, in particular no less than 4 MPa and no higher than 6 MPa. Though in a case of general multilayer boards, the multilayer board is often layered under 2 MPa to 3MPa, in a case of the present embodiment, film 102 is thin and easily subjected to the effects of inconsistency in thickness, and in addition, conductive paste 126 is used, and therefore, it is desirable for the pressure for layering to be approximately 5 MPa, which is relatively high, for example a pressure of no lower than 4 MPa and no higher than 6 MPa.

Description in further detail is given below. First, a commercially available glass epoxy based material, concretely, a woven cloth where glass fibers are used and impregnated with an epoxy based resin, is selected as a prepreg in cloth form. Then, as shown in FIG. 2A, a protective film (not shown) is formed on the prepreg, and through holes 124 are formed at predetermined positions in this state. Next, a predetermined amount of conductive paste 126 is added on top of the above described protective film, and the above described conductive paste 126 is rubbed against the protective film with a squeegee (rubber pallet), so that through holes 124 formed in the prepreg 122 are filled in with the conductive paste. After that, the protective film is peeled off, so that a state as that in FIG. 2B is gained.

Next, a two-sided copper covered film is prepared. Concretely, a polyimide film (thickness: 10 µm) where conductive layers are formed on both sides without using an adhesive is used. Next, the conductive layers on the above described two-sided copper covered film are processed into a predetermined pattern, and thus, two-sided board 114a of FIG. 2C is gained.

Next, as shown in FIG. 2D, two-sided boards 114a and 114b are positioned on both sides of prepreg 122 of which the through holes are filled in with conductive paste 126 using a predetermined jig (not shown). After that, they are integrated through pressing for a predetermined period of time at a predetermined temperature using a vacuum press. At this time, it is desirable to apply heat and pressure if necessary. At the same time as this integration, second wires 106a and 106b formed on the prepreg 122 side of two-sided boards 114a and 114b are electrically connected through conductive paste 126.

In this manner, an extremely thin multilayer board as that shown in FIG. 2E is fabricated. Here, the thickness of prepreg 122 can further be reduced to, for example, 40 µm to 20 µm, and further to 10 µm, and thus, an extremely thin multilayer board of which the total thickness is no greater than 100 µm, or no greater than 60 µm, and furthermore, no greater than 30 µm, can be manufacture.

As described above, a four-layer printed wiring board characterized in that electrical connection in portions which penetrate through the second insulating layer counting from the front layer of the four layer printed wiring board is achieved through paste connection layer 116 made of conductive paste 126, and the second wires provided in the second layer counting from the front layer and the third wires provided in the third layer counting from the front layer are buried in the above described paste connection layer can be fabricated.

Here, the second insulating layer counting from the front layer of the four layer printed circuit board corresponds to insulating layer 108 in FIG. 1. The first insulating layer in the first layer counting from the front layer of the four layer printed circuit board corresponds to film 102a in FIG. 1. The wires provided in the second layer from the front layer correspond to second wires 106a formed beneath two-sided board 114a in FIG. 1.

In addition, the wires provided in the third layer from the front layer correspond to second wires 106b which are formed on two-sided board 114b and buried on the paste connection layer 116 (or insulating layer 108) side in FIG. 1.

As described above, in the second embodiment, the wires in the second layer counting from the front layer and the wires in the third layer counting from the front layer (corresponding to second wires 106a and 106d in FIG. 1) are both buried in paste connection layer 116 in the same manner, and therefore, the thickness of the wires does not affect the thickness of the board, even in a case where the board is thin, and thus, the performance when chip parts and semiconductor chips are mounted and bare chips are mounted using bumps where flatness is required on the surface can be improved, including cases when the multilayer board is applied to interposers for mounting a CPU.

As described above, paste connection layer 116 is made of prepreg 122 and conductive paste 126 with which through holes 124 formed in the above described prepreg 122 are filled in, and thus, IVH's 110 can be freely designed and formed at any position, so that it becomes possible to reduce the size and improve the performance of the circuit board.

### (Third Embodiment)

In the following, the multilayer board according to the third embodiment of the present invention is described in reference to the drawings. The third embodiment is different from the first embodiment in the number of films used for multilayer (two in the first embodiment while three in the third embodiment).

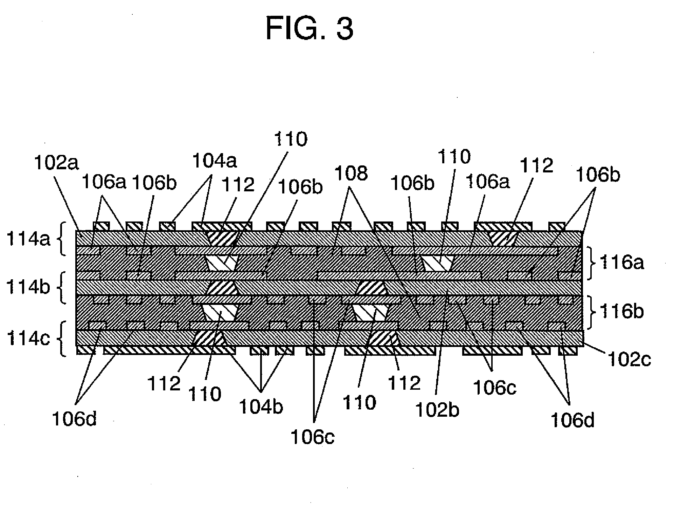

FIG. 3 is a cross sectional diagram showing a multilayer board according to the third embodiment. FIG. 3 shows two-sided boards 114a, 114b and 114c made of films which are pasted together using two paste connection layers 116a and 116b. In addition, second wires 106a formed on the lower surface of two-sided board 114a are electrically connected to second wires 106b formed on the upper surface of two-sided board 114b through IVH's 110. In the same manner, second wires 106d formed on the upper surface of two-sided board 114c are electrically connected to second wires 106c formed on the lower surface of two-sided board 114b through IVH's 110.

In this manner, three two-sided boards 114a, 114b and 114c (the number of wire layers can be calculated as 2 wires layers × 3 = 6 layers) are integrated using paste connection layers 116a and 116b, and thus, four wire layers from among the six wire layers can be buried in the above described paste connection layers 116a and 166b, so that the thickness of the four wire layers do not affect the total thickness, making further reduction in thickness possible.

Here, paste connection layers 116a and 116b are formed of insulating layers 108 and IVH's 110. Here, IVH's 110 means inner via holes (via holes for interlayer connection), and in a case of the present embodiment, IVH's 110 can be formed at arbitrary positions. In addition, prepregs 122 can be used as the insulating members for forming paste connection layers 116. In addition, it is desirable to use curing conductive paste 126 as a conductive member for forming IVH's 110. Thus, according to the present invention, prepregs and a hardening conductive paste are used, and therefore, a multilayer board can be formed without using an adhesive, and thus, the thickness of the multilayer board can be greatly reduced.

As described above, the printed wiring board with no less than five insulating layers has paste connection layer 116 where electrical connection is achieved through conductive paste 126 which penetrates through at least the insulating layer which is the second layer from the front (insulating layer 108 on the upper side in FIG. 3) in such a manner that at least wires in the second layer from the front layer (second wires 106a in FIG. 3) and wires in the third layer from the front layer (second wires 106b in FIG. 3) are buried in the above described conductive paste connection layer 116, and thus, the thickness of the multilayer printed wiring board having five or more insulating layers can be reduced.

Here, the paste connection layers, where electrical connection is achieved through the insulating layer which is the second layer from the front layer using a conductive paste, are paste connection layers 116a and 116b in FIG. 3. In addition, the first insulating layer counting from the front layer corresponds to film 102a in FIG. 3. The wires in the second layer, which are provided in the second layer counting from the front layer, correspond to second wires 106a and 106d buried in the paste connection layers 116a and 116b, which are formed on two-sided boards 114a and 114c, respectively, counting from the top and the bottom in FIG. 3. In addition, wires in the third layer counting from the front layer (counting only the number of layers having wires) in FIG. 3 correspond to second wires 106b which are formed on two-sided board 114b and buried in paste connection layer 116a. They also correspond to second wires 106c formed on the surface of two-sided board 114b counting from the bottom to the top.

### (Fourth Embodiment)

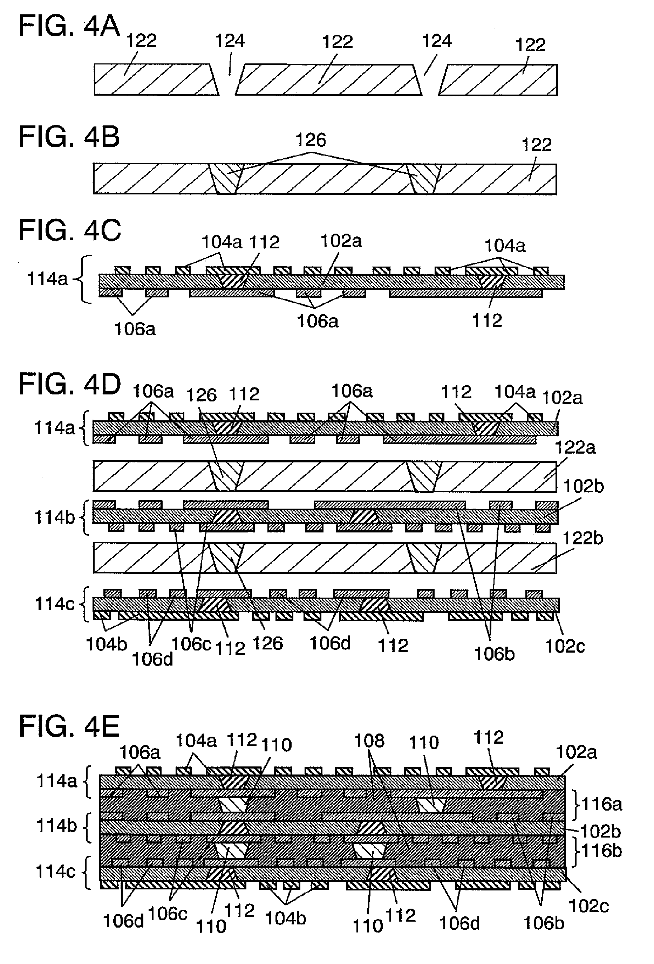

In the following, the manufacturing method for a multilayer board according to the fourth embodiment of the present invention is described in reference to the drawings. FIGS. 4A to 4E are cross sectional diagrams for illustrating the manufacturing method for a multilayer board according to the fourth embodiment. The fourth embodiment is an example of a manufacturing method according to which a plurality of films are layered, which is an example of a manufacturing method for, for example, the multilayer board according to the third embodiment.

First, as shown in FIG. 4A, through holes 124 are formed in prepreg 122. At this time, through holes 124 can be formed in a state where a protective film is pasted on the surface of prepreg 122. In addition, these through holes 124 can be formed using a die, a drill, a laser or the like. In addition, a commercially available product in cloth form, for example, can be used as the prepreg. Next, as shown in FIG. 4B, through holes 124 are filled in with conductive paste 126. Screen printing can be used for this filling. Through holes 124, for example, are formed so as to penetrate through both prepreg 122 and the protective film formed on top of the prepreg (not shown), and after that, a conductive paste is rubbed against the above described protective film which is used as a mask using a squeegee or the like, and thus, it is possible to fill in only through holes 124 formed in prepreg 122 with conductive pate 126 in a self-alignment manner. Then, the above described protective film is peeled off, so that a state as that in FIG. 4B is gained.

FIG. 4C is a cross sectional diagram showing two-sided board 114a. In FIG. 4C, first wires 104a and second wires 106a are formed on the surfaces of film 102a and electrically connected via interlayer connection portions 112. As film 102a, it is desirable to use a film member having high strength and a low coefficient of thermal expansion, such as a polyimide film or a polyamide film, and an aramid film is particularly preferable. Resin film 102a having a small coefficient of thermal expansion (specifically, a coefficient of thermal expansion which is close to that of silicon) is used, so that the multilayer board can be used for mounting bare chips of semiconductor chips, and can be used as an interposer around a CPU. In terms of the thickness of film 102, it is desirable to select 100 µm or less, particularly 3 µm or more and 50 µm or less, desirably 30 µm or less, and furthermore, 25 µm or less, if possible. A very thin film having resistance to heat is used in this manner, and thus, the total thickness of the completed multilayer board can be reduced. Here, a board material where conductive layers are formed on both sides of such a film having resistance to heat without using an adhesive can be selected. A copper covered film where a film having resistance to heat and a copper foil are pasted together without using an adhesive as described above, and thus, the resistance to heat of the multilayer board can be increased, and therefore, the multilayer board is easy to use for mounting parts using lead-free solder.

FIG. 4D is a cross sectional diagram showing the manner in which the position of prepregs 122a and 122b of which the voids are filled in with conductive paste 126 in FIG. 4B and a plurality of two-sided boards 114a, 114b and 114c relative to each other is adjusted.

FIG. 4E is a cross sectional diagram showing a state after prepregs 122a and 122b of which the voids are filled in with conductive paste 126 in FIG. 4B and two-sided boards 114a, 114b and 114c are integrated with each other. Concretely, the layers in the sample in a state shown in FIG. 4D are pressed against each other using a thermal board press or the like and heated at a predetermined profile of temperature, and thus, prepregs 122a and 122b are once softened, and after that, hardened, so as to be converted to insulating layers 108. At this time, conductive paste 126 with which the voids in prepregs 122a and 122b are filled in is also heated and hardened so as to be converted to IVH's 110.

Description in further detail is given below. First, a commercially available aramid epoxy based product is used as prepreg 122. Then, as shown in FIG. 4A, through holes 124 are formed at predetermined positions in prepreg 122 and the protective film on top. Next, a predetermined amount of conductive paste 126 is added on top the above described protective film, and through holes 124 formed in prepreg 122 are filled in with the above described conductive paste 126 using a squeegee (rubber pallet). Then, the protective film is peeled off, and thus, a state as that in FIG. 4B is gained.

Next, a two-sided copper covered film is prepared. Concretely, an aramid film having a thickness of 10 µm where conductive layers are formed on the two sides without using an adhesive is used. Next, the copper foil portions of the above described two-sided copper covered film are processed into a predetermined pattern, and thus, two-sided board 114a as that in FIG. 4C is provided.

Next, as shown in FIG. 4D, prepregs 122a and 122b of which the voids are filled in with conductive paste 126 and two-sided boards 114a, 114b and 114c are layered on top of each other after their position is adjusted. After that, heat and pressure are applied at a predetermined temperature using a press for a predetermined period of time, so that the layers are integrated. At this time, vacuum pressing may be used, if necessary. In addition, the conditions for pressing are such that prepreg 122 once softens, and after that, hardens, and thus, a plurality of two-sided boards 114 can be integrated using prepreg 122, which is set in between. In addition, under these conditions for pressing, conductive paste 126 electrically connects second wires 106a to 106d formed on the prepreg side of two-sided boards 114.

In this manner, a very thin multilayer board is fabricated, as shown in FIG. 4E. Here, when the thickness of prepregs 122a and 122b is small (for example 40 µm or 20 µm, desirably 10 µm), a very thin multilayer board of which the total thickness is no greater than 100 µm or no greater than 60 µm, and furthermore, no greater than 30 µm, can be manufactured.

### (Fifth Embodiment)

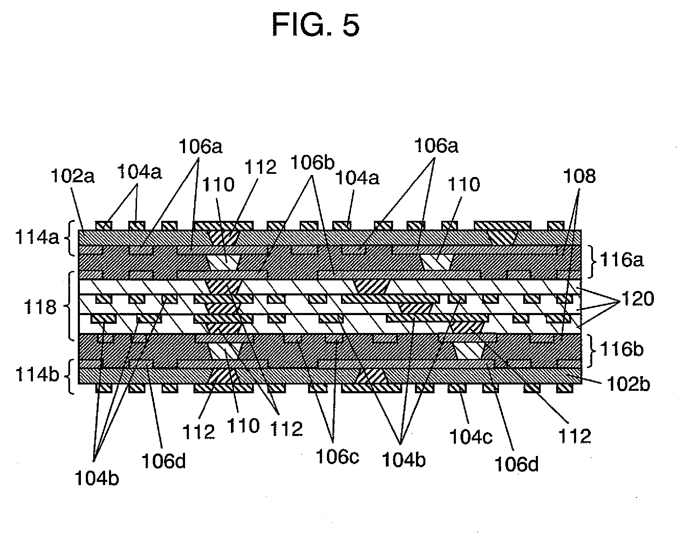

In the following, the multilayer board according to the fifth embodiment of the present invention is described. FIG. 5 is a cross sectional diagram showing the multilayer board according to the fifth embodiment. The fifth embodiment is different from the third embodiment in that the multilayer board of the third embodiment has two board layers in the center portion and the multilayer board of the fifth embodiment has three or more layers in the center portion. Thus, according to the fifth embodiment, multilayer boards in a variety of forms can be formed, in addition to two-sided boards made of films.

In FIG. 5, multilayer board 118 is formed of wires 104b in a plurality of layers which are isolated from one another with interlayer insulating layers 120 and interlayer insulating layers 120, and second wires 106b and 106c are formed on the surface of interlayer insulating layers 120. Here, in FIG. 5, second wires 106b and 106c formed on the surface of multilayer board 118 are both buried in paste connection layers 116a and 116b.

In the same manner, first wires 104a and 104c, as well as second wires 106a and 16d, are formed on the surface of films 102a and 102b and electrically connected to each other through interlayer connection portions 112, and thus, two-sided boards 114a and 114b are formed.

In addition, as shown in FIG. 5, second wires 106a which are formed on the paste connection layer 116a side of two-sided board 114a and second wires 106b which are formed on the paste connection layer 116a side of multilayer board 118 are both buried in paste connection layer 116a and electrically connected through IVH's 110. In the same manner, second wires 106d on two-sided board 114b and second wires 106c on the surface of multilayer board 118 are connected through IVH's 110 which penetrate through paste connection layer 116b.

Thus, multilayer board 118 is placed at the center, and two-sided boards 114a and 114b are formed on the two sides thereof, so that the wires are buried in paste connection layers 116, and therefore, the thickness of the wires does not affect the total thickness, and thus, interlayer connection can be achieved. In addition, no adhesive is used in the fifth embodiment, and therefore, it is possible to reduce the thickness.

### (Sixth Embodiment)

The manufacturing method for a multilayer board according to the sixth embodiment is described in detail in reference to FIGS. 6A to 6F. FIGS. 6A to 6F are cross sectional diagrams for illustrating the manufacturing method for a multilayer board according to the sixth embodiment, and the manufacturing method for this multilayer board corresponds to a manufacturing method for, for example, the multilayer board according to the fifth embodiment, which is described in reference to FIG. 5.

First, as shown in FIG. 6A, through holes 124 are formed in prepreg 122. Through holes 124 can be formed using a die, a drill, a laser or the like. In addition, a commercially available product can be used for the prepreg. Next, as shown in FIG. 6B, through holes 124 are filled in with conductive paste 126.

FIG. 6C is a cross sectional diagram showing two-sided board 114a. In FIG. 6C, two-sided board 114a is formed of film 102a, as well as first wires 104a and second wires 106a which are formed on the surface of the film, which are connected through interlayer connection portions 112. FIG. 6D is a cross sectional diagram showing multilayer board 118. Multilayer board 118 is formed of interlayer insulating layers 120, interlayer connection portions 112 and first wires 104b. In addition, first wires 104b which are formed in different layers are connected via interlayer connection portions 112 which are formed in interlayer insulating layers 120. FIG. 6E shows the manner in which the position of prepregs of which the voids are filled in with conductive paste 126 in FIG. 6B and multilayer board 118 in FIG. 6D relative to each other is adjusted. In addition, these are integrated using a vacuum pressing apparatus (not shown). FIG. 6F is a cross sectional diagram showing the manner in which the members in FIG. 6E are integrated.

Next, an example where second wires 106a, 106b, 106c and 106d are buried in prepregs 122 is described. The layers in the sample, which are in a state as that shown in FIG. 6D, are pressed against each other, for example using vacuum pressing (or vacuum pressing and application of heat), and are heated at a predetermined profile of temperature, so that prepregs 122 soften and second wires 106a, 106b, 106c and 106d are buried in prepregs 122. After that, prepregs 122 harden so as to be converted to insulating layers 108. In addition, conductive paste 126 with which the voids in prepregs 122 are filled in is simultaneously heated and hardened, and thus, electrically connects second wires 106a and 106b formed in different layers, and becomes IVH's 110.

Description in further detail is given below. First, a commercially available glass epoxy based product having a thickness of 30 µm is used as the prepreg. In addition, as shown in FIG. 6A, through holes 124 are formed at predetermined positions in the prepreg, as well as in the protective film on top. Here, the protective film is not shown in FIG. 6A. Next, a predetermined amount of conductive paste 126 is added on top of the above described protective film, and through holes 124 formed in prepregs 122 are filled in with the above described conductive paste 126, which enters through the holes in the above described protective film, using a squeegee (rubber pallet). After that, the protective film is peeled off, and a state as that in FIG. 6B is gained. Here, the protective film is not shown in FIG. 6B.

Next, a two-sided copper covered film is prepared. Concretely, a polyimide film having a thickness of 10 µm where conductive layers are formed on the two surfaces without using an adhesive is used. Next, the copper foil portions of the above described two-sided copper covered film are processed into a predetermined pattern, and thus, two-sided board 114a of FIG. 6C is gained. It can be seen from FIG. 6C that first wires 104a and second wires 106a are formed on the two surfaces of film 102a on two-sided board 114a.

In addition, multilayer board 118 shown in FIG. 6D is prepared. In FIG. 6D, first wires 104b are insulated from one another with interlayer insulating layers 120, and interlayer connection is achieved through interlayer connecting portions 112. In addition, second wires 106b and 106c are formed on the surfaces of multilayer board 118.

Next, as shown in FIG. 6E, multilayer board 118, as well as two-sided boards 114a and 114b, are set on the two surface of prepregs 122 of which the voids are filled in with conductive paste 126. After that, as shown in FIG. 6F, these are pressed against each other for a predetermined period of time at a predetermined temperature so as to be integrated. At this time, vacuum pressing may be used, if necessary. In addition, under these conditions for pressing, conductive paste 126 is electrically connected to second wires 106a and 106d formed on the prepreg side of two-sided boards 114a and 114b.

In this manner, as shown in FIG. 6F, a very thin multilayer board is fabricated. Here, when the thickness of the films, prepregs 122 and multilayer board 118 is small, for example 40 µm or 20 µm, more desirably 10 µm, a very thin printed wiring board having many layers can be manufactured.

Next, the prepregs are described. Here, prepreg (sheet material on which an impregnating process is carried out in advance) is a fiber material or woven cloth impregnated with an active resin. This is in such a state as not to be completely cured yet, and therefore, the entirety can be formed at once through application of energy. In this manner, prepregs are used, and thus, wires can be prevented from short circuiting through contact between wires at the time of formation, and furthermore, deformation and inconsistency in the dimensions can be prevented at the time of press forming, and it is also possible to increase the strength of the completed multilayer board. Here, it is desirable to use a thermoplastic resin as the resin which is impregnated. As the thermosetting resin, an epoxy resin or an imide resin can be used. In addition, members made of polyamide including an aromatic based resin or aramid can be used, in addition to glass fibers as the fiber material or woven cloth.

Here, it is desirable for the temperature at which the prepregs are hardened to be in a range from 85 °C to 220 °C. In a case where the temperature is 230 °C or higher, there is inconsistency in the curing of the resin, which sometimes affects the precision in terms of the dimensions. In addition, in a case where the temperature is lower than 85 °C, the time it takes for the resin to be cured is long, which sometimes affects the cured state. In addition, in a case where the thickness of film 102 is as small as 50 µm or lower, it is desirable for prepregs 122 to be cured in a temperature range of 180 °C or higher and 220 °C or lower. Thus, second wires 106a and 106d formed on the prepreg 122 side from among the wires formed on the surface of two-sided boards 114a and 114b can be buried in prepregs 122.

In addition, it is desirable for the pressure range to be 2 MPa (megapascals; unit for pressure) or higher and 6 MPa or lower. In a case of less than 2 MPa, there is a possibility that there may be inconsistency in the adhesiveness of the multilayer board shown in FIG. 6F. In addition, it is desirable for the time for applying pressure to be 1 minute or longer, and shorter than 3 hours. In a case where the time for applying pressure is less than 1 minute, sometimes there is inconsistency due to the pressure. In addition, in a case where the time for applying pressure exceeds 3 hours, the productivity is affected. Therefore, it is desirable for the pressure to be no less than 2 MPa and no higher than 6MPa, in particular no less than 4 MPa and no higher than 6 MPa. Though in a case of general multilayer boards, the multilayer board is often layered under 2 MPa to 3MPa, in a case of the present embodiment, film 102 is thin and easily subjected to the effects of inconsistency in thickness, and in addition, conductive paste 126 is used, and therefore, it is desirable for the pressure for layering to be approximately 5 MPa, which is relatively high, for example a pressure of no lower than 4 MPa and no higher than 6 MPa.

Then, as shown in FIG. 6E, two-sided boards are set and positioned on the two sides of prepregs 122 of which the voids are filled in with conductive paste 126, and after that, heat and pressure are applied using a pressing apparatus, so that the layers are integrated. Here, in terms of the conditions for pressing, an optimal pressing program, concretely, a program in which the temperature increases step by step from room temperature to approximately 200 °C and the temperature automatically lowers to room temperature, and the pressure also changes over time, is used, and thus, it becomes possible to stably manufacture the products. Thus, a multilayer board as that shown in FIG. 6F is manufactured.

### (Seventh Embodiment)

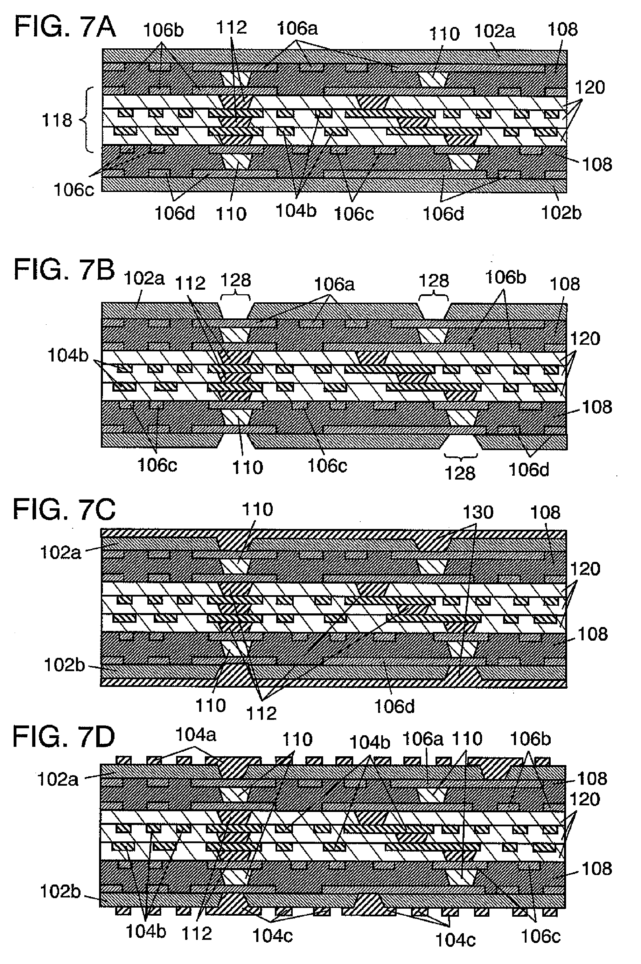

Next, the seventh embodiment is described in reference to FIGS. 7A to 7D. A case where interlayer connection is achieved and wires on the front layers are formed using a plating technology in a multilayer board where the front layer is a film is described as the seventh embodiment.

FIGS. 7A to 7D are cross sectional diagrams for illustrating the manufacturing method for a multilayer board according to the seventh embodiment, and this manufacturing method for a multilayer board is an example of a manufacturing method for, for example, the multilayer board described in the sixth embodiment, and can be applied for the multilayer boards according to the first and third embodiments. In particular, the present seventh embodiment is characterized in that the wires on the front layers of the multilayer board and the interlayer connecting portions which are connected to these wires are integrated using a plating technology, and a microscopic pattern for higher performance can be formed.

The seventh embodiment is characterized by having blind vias 128 shown in FIG. 7B and metal films 130 shown in FIG. C. First, the description refers to FIG. 7A. FIG. 7A is a cross sectional diagram showing a multilayer board where the front layers are resin films 102a and 102b. In FIG. 7A, multilayer board 118 is formed of interlayer insulating layers 120, first wires 104b and interlayer connection portions 112 at the center. In addition, second wires 106b and 106c on multilayer board 118 on the side facing insulating layers 108 are connected to second wires 106a and 106d formed on films 102a and 102b on the side facing insulating layers 108 via IVH's 110, if necessary. In this manner, second wires 106b and 106c formed on the surfaces of multilayer board 118 are electrically connected to second wires 106a formed on film 102a and second wires 106d formed on film 102b via IVH's 110.

The two surfaces of the multilayer board shown in FIG. 7A are covered with films 102a and 102b. Next, the manner in which wires and the like are formed on the surface of films 102a and 102b is described in reference to FIGS. 7B to 7D.

FIG. 7B is a cross sectional diagram showing the multilayer board shown in FIG. 7A with films 102a and 102b formed on the two surfaces after holes are formed in the films. In FIG. 7B, blind vias 128 are formed in films 102a and 102b in the front layers, and second wires 106a and 106d formed on films 102a and 102b on the insulating layer 108 side are exposed from the inside or the bottom of blind vias 128.

FIG. 7C is a cross sectional diagram showing the manner in which metal films 130 are formed on films 102a and 102b so that blind vias 128 are filled in. In FIG. 7C, metal films 130 are formed on the surface of films 102a and 102b, and at the same time, blind vias 128 can also be coated with metal films 130. As the method for forming these metal films 130, a plating method, a thin film method or the like can be used. In addition, metal films 130 may be formed on both sides of the board as shown in FIG. 7C, or may be formed on only one side, if necessary. In addition, as shown in FIG. 7C, metal films 130 which are formed so as to cover blind vias 128 are electrically connected to second wires 106a and 106d which are formed on films 102 on the insulating layer 108 side.

FIG. 7D is a cross sectional diagram showing metal films 130 after they are formed into a predetermined pattern through etching or the like. As shown in FIG. 7D, the portions of metal films 130 which cover blind vias 128 are left as they are, as via fillers or a via filling material, when metal films 130 are patterned into a predetermined form, and thus, first wires 104a are provided. Then, first wires 104a are electrically connected to second wires 106a via blind vias 128.

In this manner, a least one of wires in the first layer counting from the front layer (corresponding to wires 104a in FIG. 7D) and wires in the second layer counting from the front layer (corresponding to wires 106a in FIG. 7D) are secured to the first insulating layer via a plating film, and thus, it becomes possible to form metal films 130 and first wires 104a and 104b, as well as second wires 106a and 106d, on the surface of films 102a and 102b as very thin films at low cost, and furthermore, wires having little inconsistency in thickness can be provided.

In this manner, as shown in FIGS. 7C and 7D, metal films 130 are formed in blind vias 128, and thus, it becomes possible to achieve electrical connection through the first insulating layer counting from the front layer, that is to say, electrical connection between first wires 104a and 104c and second wires 106a and 106d via blind vias 128 formed in films 102a and 102b, and therefore, highly reliable interlayer connection with a low wire resistance becomes possible.

### (Eighth Embodiment)

According to the eighth embodiment, a manufacturing method for a multilayer board where a thin film method is used instead of a plating method or a thin film method and a plating method are combined is described. The eighth embodiment is different from the seventh embodiment in that it uses a thin film method (eighth embodiment), as opposed to a plating method (seventh embodiment), but the two have many points in common, and the eighth embodiment is described in reference to FIG. 7.

First, for forming blind vias 128 shown in FIG. 7B, a laser apparatus, for example YAG, CO₂ or the like, can be used. As the method for forming metal films 130 on the surfaces having blind vias 128 and the like, first, approximately 10 Å to 50 Å of a base layer (sometimes referred to as seed layer) made of, for example, NiCr, is formed, and electrically plated with copper. Alternatively, electroless plating of copper may be carried out on films 102a and 102b without using a seed layer. Alternatively, copper may be deposited directly on films 102 in accordance with a thin film method (electron beam, sputtering or the like). In these cases, the plating may have a thickness of 10 Å or more, or more desirably, the thickness required for the wire; that is, in a case where the wire has a conductivity which is sufficient for electrolytic plating, the wire is electrically plated with copper based on this conductivity, so that the wire becomes sufficiently conductive (for example 5 µm to 30 µm is desirable, or approximately 3 µm to 15 µm, in a case where the layer must be thin). A seed layer or a metal base layer is used in this manner, or the method for forming a metal wire is modified, and thus, the adhesiveness of the member to films 102a and 102b can be increased.

In this manner, at least one of wires in the first layer counting from the front layer and wires in the second layer counting from the front layer are secured to the first insulating layer counting from the front layer via a film made through sputtering, and thus, the adhesiveness of metal films 130, first wires 104a and 104c, and second wires 106a and 106d to the surface of films 102a and 102b can be increased.

### (Ninth Embodiment)

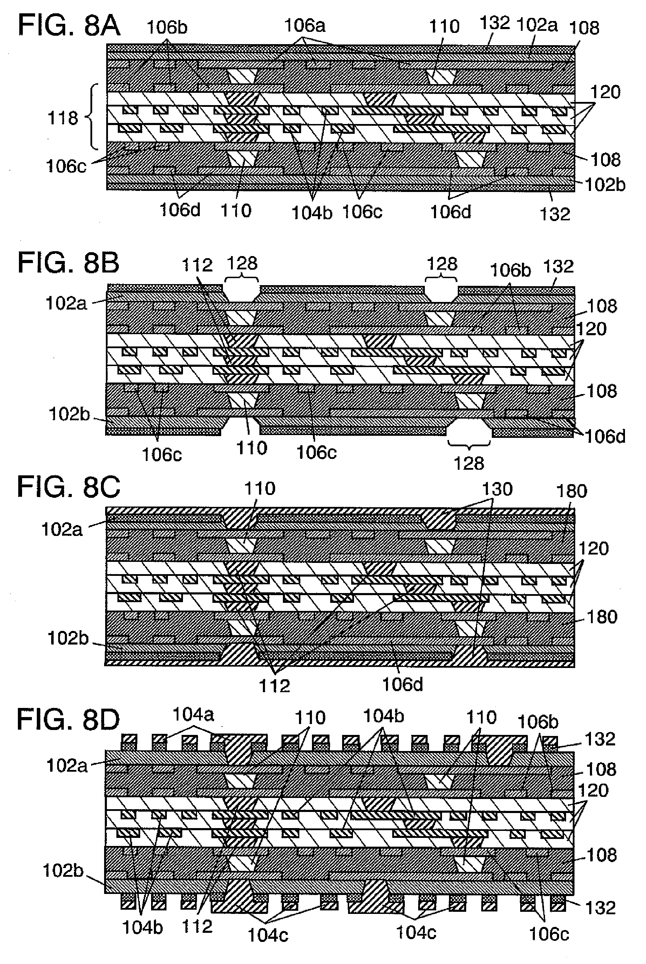

Next, the manufacturing method for a multilayer board according to the ninth embodiment is described. The ninth embodiment is described in reference to FIGS. 8A to 8D. FIGS. 8A to 8D are cross sectional diagrams for illustrating the ninth embodiment, and the ninth embodiment is characterized by having base electrode layers 132. The ninth embodiment (shown in FIGS. 8A to 8D) is different from the eighth embodiment (shown in FIGS. 7A to 7D) in that there are base electrode layers 132.

First, as shown in FIG. 8A, base electrode layers 132 are formed on at least the exposed surface of films 102a and 102b, and in a case where copper is used for these base electrode layers 132, the base layer (or anchor layer) is formed in accordance with a thin film method or a plating method. Base electrode layers 132 are used in this manner, and thus, the adhesiveness of wires 104a and 104c to films 102a and 102b can further be increased. In addition, a thin film of NiCr or Cr can be used as the base layer for base electrode layer 132, if necessary. That is to say, the base electrode layer may be provided as a single layer, or include a plurality of layers. In the latter case, approximately 10 Å to 50 Å of a thin film of NiCr or Cr is formed, and this is electrically plated with copper, which is a wire material, and thus, the layer is formed. Here, in a case where the thickness of NiCr or Cr is approximately 10 Å or greater and 1 µm or smaller, the conductivity is used to form a copper layer having a predetermined thickness on top, for example one of approximately 5 µm to 30 µm or approximately 3 µm to 15 µm, in a case where the layer must be thinner. Base electrode layers 132 are used in this manner, and thus, the adhesiveness of wires 104a and 104c to films 102a and 102b can be increased.

Here, as shown in FIG. 8B, blind vias 128 can be formed in films 102a and 102b, together with base electrode layers 132. Then, after that, first wires 104a and 104c having a predetermined thickness, as well as interlayer connection portions 112, can be formed in the same manner as in FIGS. 7A to 7D.

In addition, as shown in FIGS. 8C and 8D, metal films 130 are formed in blind vias 128, in the same manner as in FIGS. 7C and 7D, and thus, it becomes possible to achieve electrical connection through the first insulating layer counting from the front layer, that is to say, electrical connection between first wires 104a and 104c and second wires 106a and 106d via blind vias 128 formed in films 102a and 102b, and therefore, highly reliable interlayer connection having a low wire resistance becomes possible.

### (Tenth Embodiment)

A manufacturing method for a multilayer board using a resin film where an inorganic filler is added to the insulating layers is described as the tenth embodiment. The tenth embodiment (having an inorganic filler) is different from the second embodiment (using glass epoxy based prepregs) and the sixth embodiment (using prepregs including aramid) in terms of the content of prepregs, that is, of the additive. Here, the tenth embodiment has many points in common with the second embodiment and the ninth embodiment, and therefore, is described in reference to FIGS. 2 and 8.

Here, a ceramic based insulating powder, such as alumina or silica, is desirable as the inorganic filler which is added to the prepregs. Thus, an inorganic filler is added to the prepregs in advance, and thus, the prepregs can be prevented from being excessively fluid at the time of thermal pressing. In a case where the prepregs become excessively fluid, there is a possibility that conductive paste 126 with which through holes 124 are filled in may became fluid or shift in position, and it is desirable to prevent this. Thus, in order to prevent to a certain degree softening and fluidization of the prepregs at the time of thermal pressing, it is desirable to add 10 weight % to 85 weight % of an inorganic filler as described above, more desirably 20 weight % to 80 weight %, and furthermore, 40 weight % to 60 weight %, in a case where high precision is required. Here, in a case where the amount of inorganic filler added is too small, it is easy to bury second wires 106a, 106b, 106c and 106d, but there is a possibility that paste connecting layer 116 may be negatively affected. In addition, in a case where the amount of inorganic filler added is too great, though there is a possibility that paste connection layer 116 may not become fluid at the time of thermal pressing, shift or become difficult to be moved in a desired direction, there is also a possibility that the properties for burying second wires may be negatively affected; for example, there is a possibility that the unevenness of the second wires may affect the total thickness.

Furthermore, conductive paste 126 can be prevented from softening, becoming abnormally fluid and deforming at the time of thermal pressing by adding an inorganic filler. In addition, the possibility there being a connection defect in IVH's 110 can be lowered.

It is desirable for the average particle diameter of the added inorganic filler to be no smaller than 0.5 µm and no greater than 5 µm. In a case of less than 0.5 µm, BET (specific surface area) becomes too great, and sometimes handling becomes difficult. In addition, in a case of greater than 5 µm, reduction in thickness of the multilayer board sometimes fails to be achieved.

### (Eleventh Embodiment)

A manufacturing method for a multilayer board using a thermosetting resin in the paste connection layers is described as the eleventh embodiment. As described in the eleventh embodiment, it is not necessary to limit the insulating members for forming the paste connecting layers to prepregs. Though they may be a thermosetting resin film, a high performance thermoplastic resin, such as an LCP (liquid crystal polymer resin) can also be used. Thus, a high precision thermoplastic resin having high strength is used, and thus, a high precision multilayer board can be manufactured.

### INDUSTRIAL APPLICABILITY

As described above, in the multilayer board and the manufacturing method for the same according to the present invention, films and multilayer boards are combined, and thus, a very thin multilayer board as did not exist in the prior art can be fabricated, and therefore, the invention can be applied in applications where various types of electronic equipment and portable equipment need to be miniaturized or reduced in thickness. Accordingly, the industrial applicability of the invention is extremely wide.

## Claims

1. A multilayer printed wiring board, comprising three insulating layers, wherein
a second insulating layer formed in the second layer counting from the front layer is provided as a paste connection layer in which a conductive paste allows electrical connection to be achieved through the second insulating layer, **characterized in that**
a second wire formed in the second layer counting from the front layer and a third wire formed in the third layer counting from the front layer are buried in the paste connection layer.

2. A multilayer printed wiring board, comprising four or more insulating layers wherein
a second insulating layer formed in the second layer counting from at least one front layer is provided as a paste connection layer in which a conductive paste allows electrical connection to be achieved through the second insulating layer, **characterized in that**
a second wire formed in the second layer counting from at least one front layer and a third wire formed in the third layer counting from the front layer are buried in the paste connection layer.

3. The multilayer printed wiring board according to Claim 1, wherein the paste connection layer is made of a prepreg and a conductive paste with which a through hole formed in the prepreg is filled in.

4. The multilayer printed wiring board according to Claim 1, wherein the paste connection layer is made of a thermosetting resin and a conductive paste with which a through hole formed in the thermosetting resin is filled in.

5. The multilayer printed wiring board according to Claim 1, wherein the paste connection layer is made of a thermoplastic resin and a conductive paste with which a through hole formed in the thermoplastic resin is filled in.

6. The multilayer printed wiring board according to Claim 1, wherein
at least one insulating layer which is an outermost layer from among the three insulating layers is made of a resin film, and
the wire is formed on the outermost insulating layer made of the resin film without an adhesive intervening.

7. The multilayer printed wiring board according to Claim 3, wherein
the prepreg is glass epoxy or aramid epoxy.

8. The multilayer printed wiring board according to Claim 4, wherein
the resin is mixed with an inorganic filler with a ratio of no lower than 10 wt % and no higher than 85 wt %.

9. The multilayer printed wiring board according to Claim 5, wherein
the resin is mixed with an inorganic filler with a ratio of no lower than 10 wt % and no higher than 85 wt %.

10. The multilayer printed wiring board according to Claim 1, wherein at least one of the wire in the first layer counting from the outermost layer and the wire in the second layer counting from the outermost layer is secured to the outermost insulating layer via a layer made through sputtering.

11. The multilayer printed wiring board according to Claim 1, wherein at least one of the wire in the first layer counting from the outermost layer and the wire in the second layer counting from the outermost layer is secured to the outermost insulating layer via a plating film.

12. The printed wiring board according to either Claim 1 or 2, wherein electrical connection is achieved by means of plating through the first insulating layer formed in the first layer counting from the front layer.

13. The multilayer printed wiring board according to Claim 1, wherein electrical connection is achieved by means of plating through the outermost insulating layer from among the three insulating layers.

14. The multilayer printed wiring board according to Claim 2, wherein the paste connection layer is made of a prepreg and a conductive paste with which a through hole formed in the prepreg is filled in.

15. The multilayer printed wiring board according to Claim 2, wherein the paste connection layer is made of a thermosetting resin and a conductive paste with which a through hole formed in the thermosetting resin is filled in.

16. The multilayer printed wiring board according to Claim 2, wherein the paste connection layer is made of a thermoplastic resin and a conductive paste with which a through hole formed in the thermoplastic resin is filled in.

17. The multilayer printed wiring board according to Claim 2, wherein
at least one insulating layer which is an outermost layer from among the four or more insulating layers is made of a resin film, and
the wire is formed on the outermost insulating layer made of the resin film without an adhesive intervening.

18. The multilayer printed wiring board according to Claim 2, wherein at least one of the wire in the first layer counting from the outermost layer and the wire in the second layer counting from the outermost layer is secured to the outermost insulating layer via a layer made through sputtering.

19. The multilayer printed wiring board according to Claim 2, wherein at least one of the wire in the first layer counting from the outermost layer and the wire in the second layer counting from the outermost layer is secured to the outermost insulating layer via a plating film.

20. The multilayer printed wiring board according to Claim 2, wherein electrical connection is achieved by means of plating through an outermost insulating layer from among the four or more insulating layers.

21. A manufacturing method for a multilayer printed wiring board, comprising:
a hole forming step of forming a through hole in an insulating base;
a paste connection layer forming step of forming a paste connection layer by filling in the through hole with a conductive paste;
a two-sided board fabricating step of fabricating a two-sided board;
a layering step of layering the two-sided board on the paste connection layer so as to fabricate a multilayer body; and
a thermal pressing step of carrying out a thermal pressing process on the multilayer body.

22. A manufacturing method for a multilayer printed wiring board, comprising:
a hole forming step of forming a through hole in an insulating base;
a paste connection layer forming step of forming a paste connection layer by filling in the through hole with a conductive paste;
a multilayer board fabricating step of fabricating a multilayer board having two or more layers;
a layering step of layering the two-sided boards on the front and rear surface of the paste connection layer so as to fabricate a multilayer body; and
a thermal pressing step of carrying out a thermal pressing process on the multilayer body.

23. The manufacturing method for a multilayer printed wiring board according to Claim 21, **characterized in that** wires formed on the front and rear surface of the two-sided board are electrically connected.

24. The manufacturing method for a multilayer printed wiring board according to Claim 21, **characterized in that** electrical connection between wires formed on the front and rear surface of the two-sided board is achieved by means of plating.

25. The manufacturing method for a multilayer printed wiring board according to Claim 21, **characterized in that** electrical connection between the front and rear surface of the two-sided board is achieved by means of a conductive paste.

26. The manufacturing method for a multilayer printed wiring board according to Claim 21, **characterized in that** an interlayer connection forming step of forming interlayer connection for electrically connecting wires on the front and rear surface of the two-sided board is carried out after the thermal pressing step.

27. The manufacturing method for a multilayer printed wiring board according to Claim 26, wherein the interlayer connection forming step has at least a via forming step of forming a blind via and a plating step of carrying out plating on the blind via.

28. The manufacturing method for a multilayer printed wiring board according to Claim 22, **characterized in that** wires formed on the front and rear surface of the two-sided board are electrically connected.

29. The manufacturing method for a multilayer printed wiring board according to Claim 22, **characterized in that** electrical connection between wires formed on the front and rear surface of the two-sided board is achieved by means of plating.

30. The manufacturing method for a multilayer printed wiring board according to Claim 22, **characterized in that** electrical connection between the front and rear surface of the two-sided board is achieved by means of a conductive paste.

31. The manufacturing method for a multilayer printed wiring board according to Claim 22, **characterized in that** an interlayer connection forming step of forming interlayer connection for electrically connecting wires on the front and rear surface of the two-sided board is carried out after the thermal pressing step.

32. The manufacturing method for a multilayer printed wiring board according to Claim 31, wherein the interlayer connection forming step has at least a via forming step of forming a blind via and a plating step of carrying out plating on the blind via.
